# EUROPEAN PATENT SPECIFICATION

(11) **EP 2 901 488 B1**
(45) Date of publication and mention of the grant of the patent: **21.07.2021**
(21) Application number: 13842457.7
(22) Date of filing: 10.06.2013
(51) Int. Cl.: H01L 21/336, H01L 29/775, H01L 29/06, H01L 29/78, H01L 29/423, B82Y 10/00

(54) **METHODS FOR MANUFACTURING NON-PLANAR SEMICONDUCTOR DEVICES HAVING GERMANIUM-BASED ACTIVE REGIONS WITH A COMBINED RELEASE-ETCH PASSIVATION STEP.**
METHODEN ZUM HERSTELLEN EINES NICHTPLANARES HALBLEITERBAUELEMENT MIT GERMANIUMBASIERTER AKTIVREGION MITTELS EINEM KOMBINIERTEN ÄTZ-FREISETZUNG PASSIVIERUNGS-SCHRITT
PROCÉDÉS DE FABRICATION DE DISPOSITIFS À SEMI-CONDUCTEUR NON-PLAN DOTÉ D'UNE RÉGION ACTIVE À BASE DE GERMANIUM AVEC ÉTAPE COMBINÉE DE PASSIVATION ET GRAVURE DE LIBÉRATION

(30) Priority: 28.09.2012 US 201213630808
(43) Date of publication of application: 05.08.2015
(73) Proprietor: Intel Corporation, Santa Clara, CA 95054 (US)
(72) Inventor: KACHIAN, Jessica, S., Portland, OR 97201 (US); RACHMADY, Willy, Beaverton, OR 97007 (US); TURKOT JR., Robert, B., Hillsboro, OR 97124 (US)
(74) Representative: Goddar, Heinz J.
(86) International application number: PCT/US2013/045029
(87) International publication number: WO 2014/051723

(56) References cited:
- JP-A- 2000 174 031
- US-A1- 2006 099 782
- US-A1- 2007 093 074
- US-A1- 2010 295 021
- US-A1- 2010 295 021
- US-A1- 2011 012 090
- US-A1- 2012 138 886
- US-A1- 2012 178 235
- PAUL W. LOSCUTOFF ET AL: "REACTIVITY OF THE GERMANIUM SURFACE: Chemical Passivation and Functionalization", ANNUAL REVIEW OF PHYSICAL CHEMISTRY., vol. 57, no. 1, 1 May 2006 (2006-05-01), pages 467-495, XP055273042, US ISSN: 0066-426X, DOI: 10.1146/annurev.physchem.56.092503.141307
- Durga Misra: "The Electrochemical Society Interface @BULLET Winter 2011 47 High k Dielectrics on High-Mobility Substrates: The Interface!", Interface; The Electrochemical Society; Winter 2011, 1 December 2011 (2011-12-01), pages 47-51, XP055272558, Retrieved from the Internet: URL:https://www.electrochem.org/dl/interfa ce/wtr/wtr11/wtr11_p047-051.pdf [retrieved on 2016-05-13]
- J.J.GU ET AL.: 'Effects of (NH4)2S passivation on the off-state performance of 3-dimensional InGaAs metal-oxide-semiconductor field-effect transistors' IEEE APPLIED PHYSICS LETTERS vol. 99, no. 15, October 2011, page 152113-2, XP 012152473
- None

## Description

### TECHNICAL FIELD

Embodiments of the invention are in the field of semiconductor devices and, in particular, non-planar semiconductor devices having germanium-based active regions with release etch-passivation surfaces.

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory devices on a chip, lending to the fabrication of products with increased capacity. The drive for ever-more capacity, however, is not without issue. The necessity to optimize the performance of each device becomes increasingly significant.

Semiconductor devices formed from germanium-based material systems offer exceptionally high hole mobility in the transistor channels due to low effective mass along with reduced impurity scattering. Such devices provide high drive current performance and appear promising for future low power, high speed logic applications. However, significant improvements are still needed in the area of germanium-based devices.

Additionally, in the manufacture of integrated circuit devices, multi-gate transistors, such as tri-gate transistors, or gate-all-around devices, such as nanowires, have become more prevalent as device dimensions continue to scale down. Many different techniques have been attempted to reduce channel or external resistance of such transistors. However, significant improvements are still needed in the area of channel or external resistance suppression, Also, many different techniques have been attempted to manufacture devices with non-Si channel materials such as SiGe, Ge, and III-V materials. However, significant process improvements are still needed to integrate these materials on Si wafers.

US 2012/138886 A1 teaches methods of forming a nanowire device comprising a substrate with source/drain structures adjacent to spacers, and silicon germanium nanowire channel structures disposed between the spacers, wherein the nanowire channel structures are vertically stacked above each other. Moreover, US 2007/093074 A1, US 2006/099782 A1 and PAUL W. LOSCUTOFF ET AL, "REACTIVITY OF THE GERMANIUM SURFACE: Chemical Passivation and Functionalization", ANNUAL REVIEW OF PHYSICAL CHEMISTRY., US, (20060501), vol. 57, no. 1, pages 467 - 495, teach processes for the passivation of germanium surfaces. Furthermore, US 2010/295021 A1 suggests a sulfuric acid-containing etchant for etching sacrificial layers.

### BRIEF DESCRIPTION OF THE DRAWINGS

FIG. 1A illustrates a cross-sectional view of a non-passivating release etch process taken along a channel region of a multi-wire semiconductor device.
FIG. 1B illustrates a cross-sectional view of a non-passivating release etch process taken along a channel region of a single-wire semiconductor device.
FIG. 2 illustrates a cross-sectional view of a passivating release etch process taken along a channel region of a multi-wire semiconductor device, in accordance with an embodiment of the present invention.
Figure 3A is a schematic representation of a germanium-based semiconductor structure having terminal sulfur-passivation.
Figure 3B is a schematic representation of a germanium-based semiconductor structure having bridging sulfur-passivation.
Figure 4A illustrates a three-dimensional cross-sectional view of a nanowire-based semiconductor structure having germanium-based active regions with a release etch-passivation surface, manufactured using the method of the present invention.
Figure 4B illustrates a cross-sectional channel view of the nanowire-based semiconductor structure of Figure 4A, as taken along the a-a' axis manufactured using the method of the present invention.
Figure 4C illustrates a cross-sectional spacer view of the nanowire-based semiconductor structure of Figure 4A, as taken along the b-b' axis, manufactured using the method of the present invention.
Figures 5A-5F illustrate three-dimensional cross-sectional views representing various operations in a method of fabricating a CMOS nanowire semiconductor structure, in accordance with an embodiment of the present invention.
Figure 6 illustrates an angled view of a non-planar semiconductor device having a germanium-based active region with a release etch-passivation surface.
Figure 7 illustrates a computing device comprising a device manufactured using the method of the present invention.

### DESCRIPTION OF THE EMBODIMENTS

Non-planar semiconductor devices having germanium-based active regions with release etch-passivation surfaces are described. The present invention relates to a method of fabricating a nanowire-based semiconductor structure according to claim 1.

Even though in the following description also for devices the term embodiment is used, the present invention only concerns the above method of manufacturing such devices. In the following description, numerous specific details are set forth, such as specific integration and material regimes, in order to provide a thorough understanding of embodiments of the present invention. It will be apparent to one skilled in the art that embodiments of the present invention may be practiced without these specific details. In other instances, well-known features, such as integrated circuit design layouts, are not described in detail in order to not unnecessarily obscure embodiments of the present invention. Furthermore, it is to be understood that the various embodiments shown in the Figures are illustrative representations and are not necessarily drawn to scale.

One or more embodiments described herein are directed to approaches for forming germanium (Ge)-containing nanowire architectures. More specifically, one or more embodiments are directed to performing a release of rectangular-shaped Ge-containing nanowires from Ge/SiGe, Ge/Si, SiGe/SiGe, or SiGe/Si multilayer stacks. Use of a hydrosulfide-based chemistry (e.g., ammonium hydrosulfide), which acts as both a sacrificial layer etchant and a Ge passivating agent, allows for conservation of the Ge-containing nanowire material during the etch and, hence, the generation of rectangular shaped nanowires or nanoribbons.

Earlier attempts to releasing nanowires, e.g., to completely expose a channel region of a nanowire for gate-all-around fabrication, have employed chemistries which act as sacrificial layer etchants only. Such solutions may result in loss of the Ge-containing channel material and, consequently, prevent formation of rectangular-shaped Ge-containing nanowires having squared corners. The conventional chemistries do not effectively passivate Ge during the sacrificial layer etch. For example, under the etch conditions previously used to consume a sacrificial layer, Ge may be easily oxidized and etched. Consequently, if Ge is not adequately passivated during the etch, it will likely be consumed at a significant rate along with the sacrificial layer.

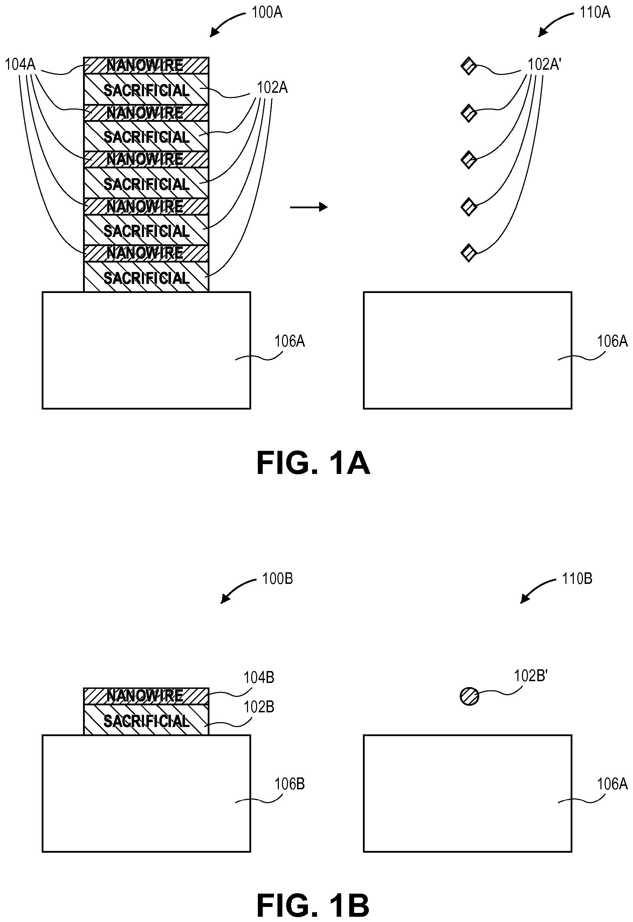

In order to address the above issues, one or more embodiments involve nanostructure release using a wet etchant that acts to passivate a preserved material while etching an adjacent sacrificial layer. That is, methods described herein employ chemistries that act more than only as mere sacrificial layer etchants. In earlier approaches, some Ge-containing channel material is consumed during the release etch, which can additionally prevent or hinder the formation of rectangular-shaped nanowires. In a first example of earlier attempts, Figure 1A illustrates a cross-sectional view of a non-passivating release etch process taken along a channel region of a multi-wire semiconductor device. Referring to Figure 1A, a channel cut of a semiconductor stack 100A having a plurality of sacrificial layers 102A and nanowire structures 104A is formed above a substrate 106A. Upon etching to remove the sacrificial layers 102A to provide released stack 110A, a portion of each of the nanowire structures 104A is etched due to poor selectivity. In the specific case shown in Figure 1A, the etch facets the nanowire structures 104A to leave etched and faceted nanowire channels 104A'.

In a second example of earlier attempts, Figure 1B illustrates a cross-sectional view of a non-passivating release etch process taken along a channel region of a single-wire semiconductor device. Referring to Figure 1B, a channel cut of a semiconductor stack 100B having a sacrificial layer 102B and nanowire structure 104B is formed above a substrate 106B. Upon etching to remove the sacrificial layer 102B to provide released structure 110B, a portion of nanowire structure 104B is etched due to poor selectivity. In the specific case shown in Figure 1B, the etch rounds the corners of the nanowire structure 104B to leave etched and rounded nanowire channel 104B'

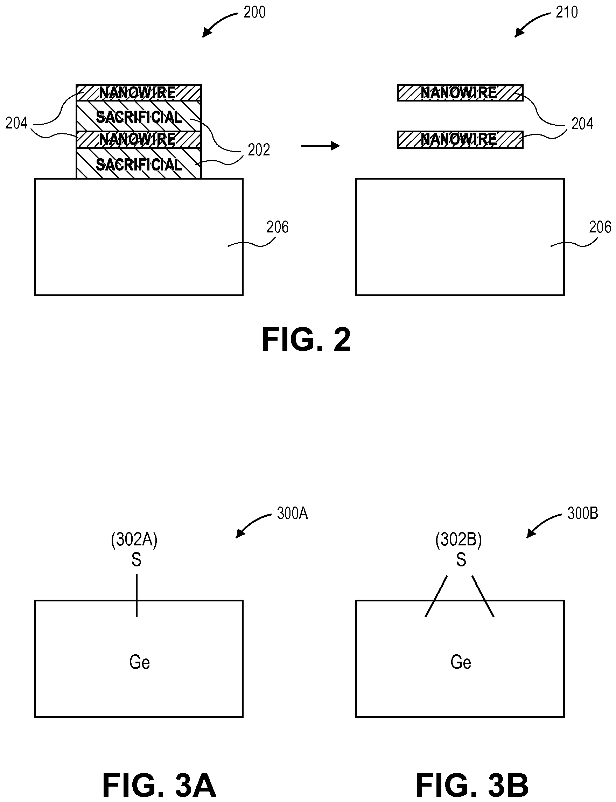

In contrast to the processes described in association with Figures 1A and 1B, one or more embodiments involve using simultaneous Ge passivation and sacrificial layer etching, allowing both selective wet-etch removal of the sacrificial layer and protection of the Ge-containing nanowire material. Such approaches prevent loss of the Ge-containing nanowire material, enabling rectangular-shaped nanowires. As an example, Figure 2 illustrates a cross-sectional view of a passivating release etch process taken along a channel region of a multi-wire semiconductor device, in accordance with an embodiment of the present invention.

Referring to Figure 2, a channel cut of a semiconductor stack 200 having a plurality of sacrificial layers 202 and germanium-based nanowire structures 204 is formed above a substrate 206. Upon etching to remove the sacrificial layers 202 to provide released stack 210, no significant portion of each of the nanowire structures 204 is etched due to high selectivity. In the specific case shown in Figure 2, rectangular nanowire structures 204 with squared corners are essentially preserved to leave released rectangular nanowire structures 204 with squared corners.

In an embodiment, a germanium-based material is preserved against a sacrificial material having less germanium during a wet etch release operation. In one embodiment, a selective chemistry that removes the sacrificial material while preserving the germanium-based material is based on an aqueous solution of ammonium sulfide (NH₄)₂S which is in equilibrium with ammonium hydrosulfide (NH4)SH. As best understood, the latter component acts to etch the sacrificial layer. Either the ammonium sulfide (NH₄)₂S or the ammonium hydrosulfide (NH4)SH, or both, acts to passivate at least a portion of the germanium-based material by providing sulfur atoms to the surface of the material. Here, chemical passivation through chemisorption provides bridging or terminal S groups. For example, Figure 3A is a schematic representation of a germanium-based semiconductor structure 300A having terminal sulfur-passivation 302A, in accordance with an embodiment of the present invention. In another example, Figure 3B is a schematic representation of a germanium-based semiconductor structure 300B having bridging sulfur-passivation 302B, in accordance with an embodiment of the present invention.

The above described sulfur passivation need not be entirely uniform nor be provided to every exposed germanium atom to effectuate suitable passivation. For example in one embodiment, although sulfur passivation may not be detected everywhere on the germanium surface, e.g., the passivation may not be perfect chemically, a suitable electrical passivation for impeding etching of the germanium material may be achieved with mere partial coverage of sulfur atoms. Whether completely chemically passivating or only partially chemically passivating (but suitably electrically passivating), the above is in contrast to conventional etching, e.g., a hydroxide (OH⁻)-based wet etch which leads to GeOₓ formation and ultimate dissolution (i.e., no passivation mechanism).

More specifically, in an embodiment, an aqueous solution of approximately 10% by weight (NH₄)₂S is used to etch a silicon-rich material (selective to a germanium-rich material) at an etch rate of about 1 nanometer/minute at a temperature of approximately 75 degrees Celsius.

According to the invention, an aqueous solution of (NH₄)₂S with a % weight approximately in the range of 1% - 25% of (NH₄)₂S is used. The pH of the solution is basic at approximately 9 +/- 1. In general, a workable etch rate is not observed below approximately 55 degrees Celsius. As for concentration, no significant concentration modulation is observed approximately between 55 and 75 degrees Celsius. In a general embodiment, a solution of (NH₄)₂S having a temperature approximately in the range of 40 - 75 degrees Celsius is used. Above approximately 75 degrees Celsius, however, concentration modulation of the (NH₄)₂S may be used to vary the etch rate of the silicon-rich material. However, selectivity against the germanium-rich material may be impacted detrimentally. Furthermore, although sonication may be used for etch rate tunability, a non-agitated solution may be preferred when handling structures with very small features undergoing a release etch (e.g., nanowire release).

More generally, in an embodiment, a silicon-rich release or sacrificial layer is etched with high selectivity to a germanium-rich semiconductor structure that is preserved. Such etches may be effective for, e.g., etching an essentially pure silicon release layer with selectivity to an essentially pure germanium structure, such as a germanium nanowire, in accordance with one embodiment. However, intermediate compositions may also benefit from etching approaches described herein. For example, in another embodiment, a silicon germanium layer is removed with selectivity to an essentially pure germanium structure. In another embodiment, a silicon germanium release layer having a first germanium concentration is removed with selectivity to a silicon germanium structure having a second, higher, germanium concentration. In yet another embodiment, an essentially pure silicon release layer is removed with selectivity to a silicon germanium structure. In a specific embodiment, an approximately Si_{0.5}Ge_{0.5} release layer is removed with selectivity to an essentially pure germanium structure. The release layer in this case has a composition suitable for germanium growth thereon but also sufficiently different for selective etching.

Semiconductor devices based on a released stack such as stack 210 (described above) or semiconductor devices 400 and 600 (described below) may be a semiconductor device incorporating a gate, a channel region and a pair of source/drain regions. The semiconductor device may be one such as, but not limited to, a MOS-FET or a Microelectromechanical System (MEMS). In an example, the semiconductor device is a three-dimensional MOS-FET and is an isolated device or is one device in a plurality of nested devices. As will be appreciated for a typical integrated circuit, both N- and P-channel transistors may be fabricated on a single substrate to form a CMOS integrated circuit. Furthermore, additional interconnect wiring may be fabricated in order to integrate such devices into an integrated circuit.

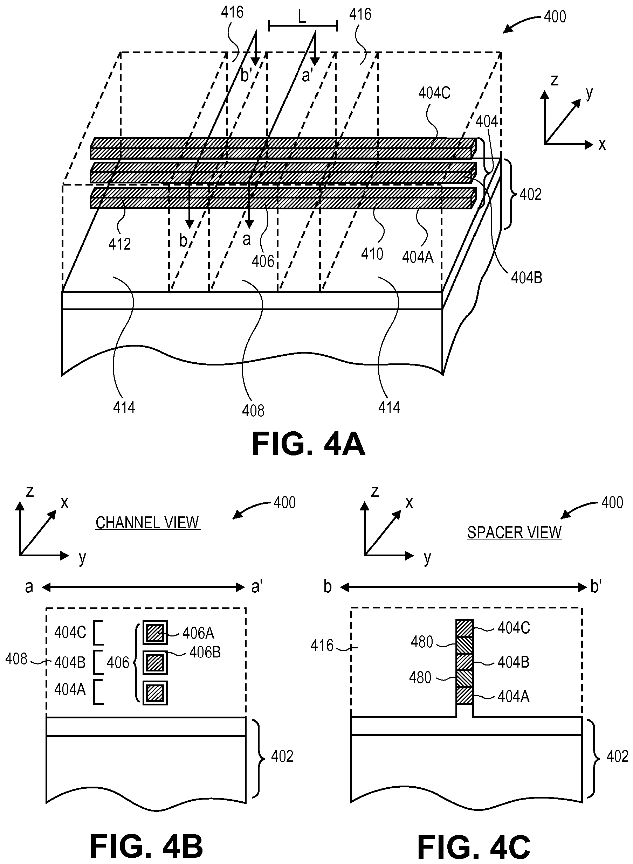

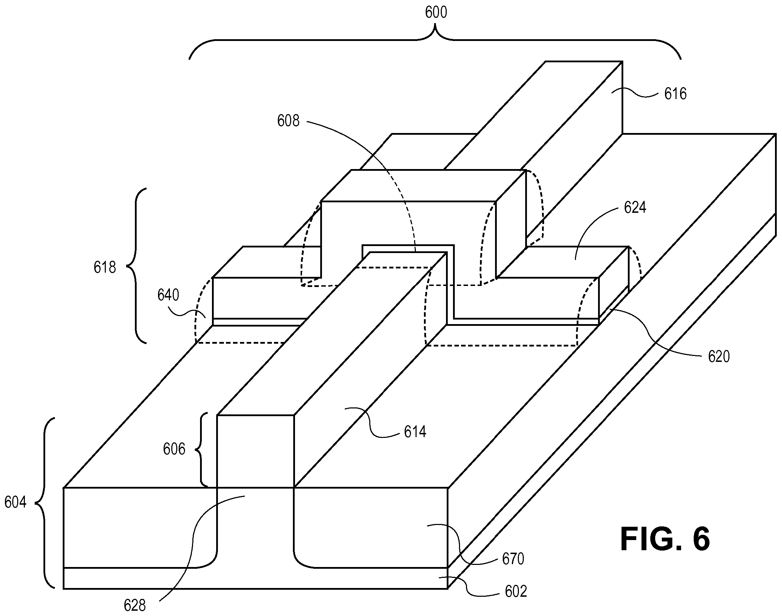

As mentioned above, a selective wet etch may be used to fabricate a germanium-based nanowire device (see more detailed description in association with Figures 4A-4C below), but may also be used in other three-dimensional semiconductor devices (e.g., devices with protruding channel regions, such as in a tri-gate or FIN-FET based MOS-FETs, particularly gate all-around devices, e.g., described below in association with Figure 6).

In a first example, Figure 4A illustrates a three-dimensional cross-sectional view of a nanowire-based semiconductor structure having germanium-based active regions with a release etch-passivation surface. Figure 4B illustrates a cross-sectional channel view of the nanowire-based semiconductor structure of Figure 4A, as taken along the a-a' axis. Figure 4C illustrates a cross-sectional spacer view of the nanowire-based semiconductor structure of Figure 4A, as taken along the b-b' axis.

Referring to Figure 4A, a semiconductor device 400 includes one or more vertically stacked nanowires (404 set) disposed above a substrate 402. Embodiments herein are targeted at both single wire devices and multiple wire devices. As an example, a three nanowire-based devices having nanowires 404A, 404B and 404C is shown for illustrative purposes. For convenience of description, nanowire 404A is used as an example where description is focused on only one of the nanowires. It is to be understood that where attributes of one nanowire are described, embodiments based on a plurality of nanowires may have the same attributes for each of the nanowires.

Each of the nanowires 404 includes a channel region 406 disposed in the nanowire. The channel region 406 has a length (L). Referring to Figure 4B, the channel region also has a perimeter orthogonal to the length (L). Referring to both Figures 4A and 4B, a gate electrode stack 408 surrounds the entire perimeter of each of the channel regions 406. The gate electrode stack 408 includes a gate electrode along with a gate dielectric layer disposed between the channel region 406 and the gate electrode (not shown). The channel region 406 is discrete in that it is completely surrounded by the gate electrode stack 408 without any intervening material such as underlying substrate material or overlying channel fabrication materials. Accordingly, in embodiments having a plurality of nanowires 404, the channel regions 406 of the nanowires are also discrete relative to one another, as depicted in Figure 4B.

In an embodiment, the channel region 406 includes a germanium-rich material portion 406A and a passivated surface 406B. It is to be understood that, for illustrative purposes, the relative thickness of the passivated surface 406B is depicted as much greater than would normally be expected. In an embodiment, the germanium-rich material portion 406A is composed of germanium (Ge) or silicon germanium (SiGe) and the passivated surface 406B is composed of germanium-sulfur bonds.

In an embodiment, the nanowires 404 may be sized as wires or ribbons (the latter described below), and may have squared-off or rounded corners. In any case, however, in an embodiment, the sizing and shaping of each channel region is essentially the same as prior to a release etch used to fabricate the discrete channel regions 406. In an embodiment, the nanowires 404 are uniaxially strained nanowires. The uniaxially strained nanowire or plurality of nanowires may be uniaxially strained with tensile strain or with compressive strain, e.g., for NMOS or PMOS, respectively.

The width and height of each of the channel regions 406 is shown as approximately the same in Figure 4B, however, they need not be. For example, in another embodiment (not shown), the width of the nanowires 404 is substantially greater than the height. In a specific embodiment, the width is approximately 2-10 times greater than the height. Nanowires with such geometry may be referred to as nanoribbons. In an alternative embodiment (also not shown), the nanoribbons are oriented vertically. That is, each of the nanowires 404 has a width and a height, the width substantially less than the height. In an embodiment, the nanowires 404 may be sized as wires or ribbons, and may have squared-off or rounded corners.

Referring again to Figure 4A, each of the nanowires 504 also includes source and drain regions 410 and 412 disposed in the nanowire on either side of the channel region 404. A pair of contacts 414 is disposed over the source/drain regions 410/412. In a specific embodiment, the pair of contacts 414 surrounds the entire perimeter of each of the source/drain regions 410/412, as depicted in Figure 4A. That is, in an embodiment, the source/drain regions 410/412 are discrete in that they are completely surrounded by the contacts 414 without any intervening material such as underlying substrate material or overlying channel fabrication materials. Accordingly, in such an embodiment having a plurality of nanowires 404, the source/drain regions 410/412 of the nanowires are also discrete relative to one another. Additionally, in an embodiment, where release layer portions are removed to provide discrete source/drain regions 410/412, a sulfur passivation layer is disposed at the outer surface of each region, e.g., resulting from a selective and passivating wet etch as described for the channel regions 406.

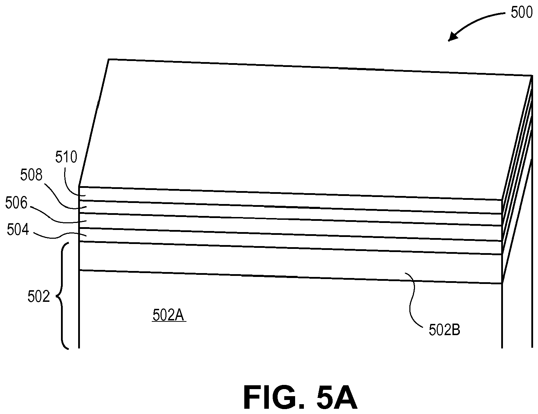

Referring again to Figure 4A, in an embodiment, the semiconductor device 400 further includes a pair of spacers 416. The spacers 416 are disposed between the gate electrode stack 408 and the pair of contacts 414. As described above, the channel regions and the source/drain regions are, in at least several embodiments, made to be discrete (e.g., by a selective and passivating wet etch process). However, not all regions of the nanowires 404 need be, or even can be made to be discrete. For example, referring to Figure 4C, nanowires 404A-404C are not discrete at the location under spacers 416. In one embodiment, the stack of nanowires 404A-404C have intervening semiconductor material 480 there between, such as silicon-rich material intervening between germanium-rich nanowires, as described below in association with Figures 5A-5F. In one embodiment, the bottom nanowire 404A is still in contact with a portion of substrate 402, e.g., in contact with an insulating layer portion disposed on a bulk substrate. Thus, in an embodiment, a portion of the plurality of vertically stacked nanowires under one or both of the spacers 416 is non-discrete.

Although the device 400 described above is for a single device, e.g., an NMOS or a PMOS device, a CMOS architecture may also be formed to include both NMOS and PMOS nanowire-based devices disposed on or above the same substrate, e.g., as described in association with Figures 5A-5F, below.

Referring again to Figures 4A-4C, the substrate 402 may be composed of a material suitable for semiconductor device fabrication. In one embodiment, substrate 402 includes a lower bulk substrate composed of a single crystal of a material which may include, but is not limited to, silicon, germanium, silicon-germanium or a III-V compound semiconductor material. An upper insulator layer composed of a material which may include, but is not limited to, silicon dioxide, silicon nitride or silicon oxy-nitride is disposed on the lower bulk substrate. Thus, the structure 400 may be fabricated from a starting semiconductor-on-insulator substrate. As such, in one embodiment, the plurality of vertically stacked nanowires 404 is disposed above a bulk crystalline substrate having an intervening dielectric layer disposed thereon, as depicted in Figures 4A-4C. Alternatively, the structure 400 is formed directly from a bulk substrate and local oxidation is used to form electrically insulative portions in place of the above described upper insulator layer. As such, in another embodiment, the plurality of vertically stacked nanowires 404 is disposed above a bulk crystalline substrate having no intervening dielectric layer disposed thereon. In another embodiment, a top barrier layer having a high band gap, such as a group III-V material barrier layer is used to isolate the bottom nanowire 404A from and underlying substrate.

In an embodiment, referring again to Figure 4A, the gate electrode of gate electrode stack 408 is composed of a metal gate and the gate dielectric layer is composed of a high-K material. For example, in one embodiment, the gate dielectric layer is composed of a material such as, but not limited to, hafnium oxide, hafnium oxy-nitride, hafnium silicate, lanthanum oxide, zirconium oxide, zirconium silicate, tantalum oxide, barium strontium titanate, barium titanate, strontium titanate, yttrium oxide, aluminum oxide, lead scandium tantalum oxide, lead zinc niobate, or a combination thereof. Furthermore, a portion of gate dielectric layer may include a layer of native oxide formed from the top few layers of the nanowire 404. In an embodiment, the gate dielectric layer is composed of a top high-k portion and a lower portion composed of an oxide of a semiconductor material. In one embodiment, the gate dielectric layer is composed of a top portion of hafnium oxide and a bottom portion of silicon dioxide or silicon oxy-nitride.

In one embodiment, the gate electrode is composed of a metal layer such as, but not limited to, metal nitrides, metal carbides, metal silicides, metal aluminides, hafnium, zirconium, titanium, tantalum, aluminum, ruthenium, palladium, platinum, cobalt, nickel or conductive metal oxides. In a specific embodiment, the gate electrode is composed of a non-workfunction-setting fill material formed above a metal workfunction-setting layer.

In an embodiment, the spacers 416 are composed of an insulative dielectric material such as, but not limited to, silicon dioxide, silicon oxy-nitride or silicon nitride. The contacts 414 are, in an embodiment, fabricated from a metal species. The metal species may be a pure metal, such as nickel or cobalt, or may be an alloy such as a metal-metal alloy or a metal-semiconductor alloy (e.g., such as a silicide material).

Referring again to Figure 4A, each of the nanowires 404 also includes source and drain regions 410/412 disposed in or on the nanowire on either side of the channel regions 406. In an embodiment, the source and drain regions 410/412 are embedded source and drain regions, e.g., at least a portion of the nanowires is removed and replaced with a source/drain material region. However, in another embodiment, the source and drain regions 410/412 are composed of, or at least include, portions of the one or more nanowires 404.

It is to be understood that although the device 400 described above is for a single device, a CMOS architecture may also be formed to include both NMOS and PMOS nanowire-based devices disposed on or above the same substrate. Thus, in another aspect, methods of fabricating nanowires using passivating etchants are provided. Figures 5A-5F illustrate three-dimensional cross-sectional views representing various operations in a method of fabricating a CMOS nanowire semiconductor structure, in accordance with an embodiment of the present invention.

A method of fabricating a nanowire semiconductor structure may, in an embodiment, include forming both a PMOS nanowire-based semiconductor device and an adjacent NMOS nanowire-based semiconductor device. Each device may be fabricated by forming a nanowire above a substrate. In a specific embodiment ultimately providing the formation of two nanowires for each of the NMOS and PMOS nanowire-based semiconductor devices, Figure 5A illustrates an initial structure 500 having a substrate 502 (e.g., composed of a bulk substrate 502A with an insulating or barrier or compositional buffer layer 502B there on). A silicon-rich layer 504/germanium-rich layer 506/silicon-rich layer 508/germanium-rich layer 510 stack is disposed on the stack 502. Of course, the ordering of such layers may be reversed.

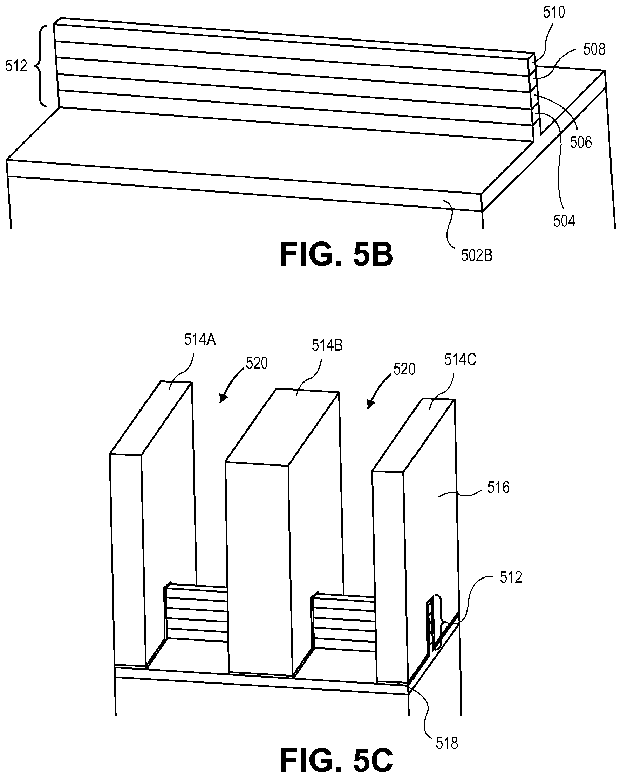

Referring to Figure 5B, a portion of the silicon-rich layer 504/germanium-rich layer 506/ silicon-rich layer 508/germanium-rich layer 510 stack as well as a top portion of the insulator or barrier or compositional buffer layer 502B is patterned into a fin-type structure 512, e.g., with a mask and plasma etch process. Thus, in an embodiment, a free surface is formed on either side of each of the silicon-rich and germanium-rich layers by patterning to provide the fin-type structure 512.

In a specific example showing the formation of three gate structures, Figure 5C illustrates the fin-type structure 512 with three sacrificial gates 514A, 514B, and 514C disposed thereon. In one such embodiment, the three sacrificial gates 514A, 514B, and 514C are composed of a sacrificial gate oxide layer 516 and a sacrificial polysilicon gate layer 518 which are, e.g., blanket deposited and patterned with a plasma etch process.

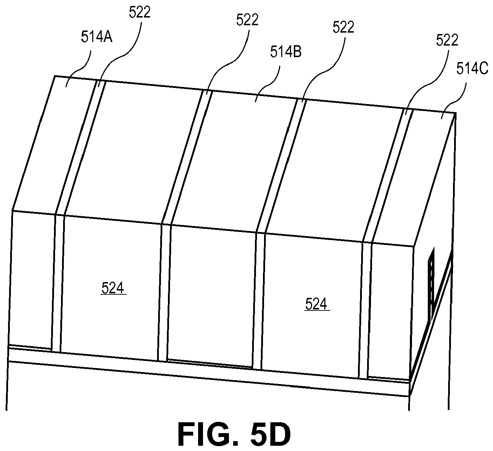

Following patterning to form the three sacrificial gates 514A, 514B, and 514C, spacers may be formed on the sidewalls of the three sacrificial gates 514A, 514B, and 514C, doping may be performed in regions 520 of the fin-type structure 512 shown in Figure 5C (e.g., tip and/or source and drain type doping), and an interlayer dielectric layer may be formed to cover and then re-expose the three sacrificial gates 514A, 514B, and 514C. The interlayer dielectric layer may then be polished to expose the three sacrificial gates 514A, 514B, and 514C for a replacement gate, or gate-last, process. Referring to Figure 5D, the three sacrificial gates 514A, 514B, and 514C are exposed, along with spacers 522 and interlayer dielectric layer 524.

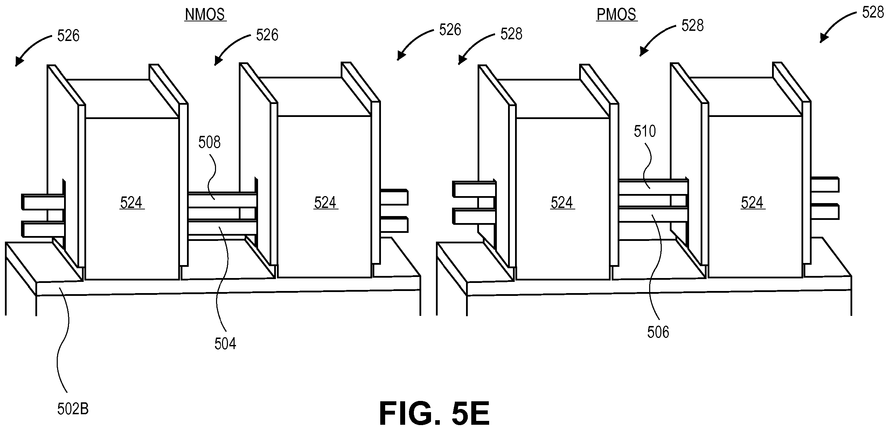

The sacrificial gates 514A, 514B, and 514C may then be removed, e.g., in a replacement gate or gate-last process flow, to expose channel portions of the fin-type structure 512. Referring to the left-hand portion of Figure 5E, in the case that the fin-type structure 512 is used to fabricate an NMOS device, the sacrificial gates 514A, 514B, and 514C are removed to provide trenches 526. Portions of the germanium-rich layers 506 and 510 exposed by the trenches 526, as well as exposed portions of the insulating or barrier or compositional buffer layer 502B, are removed to leave discrete portions of the silicon-rich layers 504 and 508. Referring to the right-hand portion of Figure 5E, in the case that the fin-type structure 512 is used to fabricate a PMOS device, the sacrificial gates 514A, 514B, and 514C are removed to provide trenches 528. Portions of the silicon-rich layers 504 and 508 exposed by the trenches 528 are removed to leave discrete portions of the germanium-rich layers 506 and 510.

In an embodiment, etching the portion of the silicon-rich release layer includes passivating exposed portions of the germanium-rich nanowire at the same time. In one such embodiment, a wet etchant based on an aqueous solution of approximately 10% by weight (NH₄)₂S is used. In a specific such embodiment, the etching is performed at a temperature approximately in the range of 55 - 75 degrees Celsius. In another specific such embodiment, the etching is performed at a temperature of approximately 75 degrees Celsius. In another specific such embodiment an etch rate of about 1 nanometer/minute is used for the silicon-rich material. In an embodiment, a pH of approximately 9 is used. In an embodiment, passivating exposed portions of the germanium-rich layers includes forming terminal sulfur-germanium bonds or bridging sulfur-germanium bonds, or both. In an embodiment, passivating exposed portions of the germanium-rich layers includes incompletely chemically passivating the exposed portions of the germanium-rich layers but sufficiently electrically passivating the exposed portions of the germanium-rich layers to inhibit etching of the exposed portions of the germanium-rich layers during etching of the silicon-rich release layers.

Thus, in an embodiment, referring to the right-hand portion of Figure 5E, the silicon-rich layers 504 and 508 are etched selectively with a wet etch that selectively removes the silicon-rich while not etching (and while additionally passivating) the germanium-rich nanowire structures 506 and 510. In another embodiment, referring to the left-hand portion of Figure 5E, the germanium-rich layers 506 and 510 are etched selectively with a wet etch that selectively removes the germanium-rich layers while not etching the silicon-rich nanowire structures 504 and 508. Thus, either the silicon-rich layers may be removed from the fin-type structure 512 to form germanium-rich channel nanowires, or the germanium-rich layers may be removed from the fin-type structure 512 to form silicon-rich channel nanowires. The discrete portions of the silicon-rich layers 504 and 508 (NMOS) or the germanium-rich layers 506 and 510 (PMOS) shown in Figure 5E will, in one embodiment, ultimately become channel regions in a nanowire-based structure.

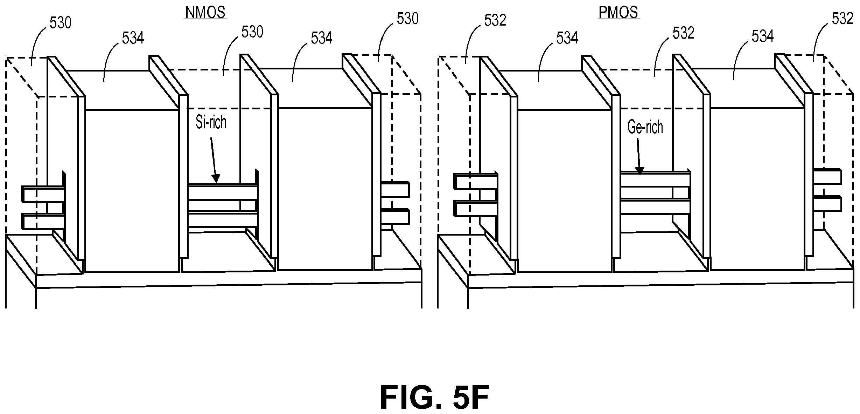

Following formation of the discrete channel regions as depicted in Figure 5E, high-k gate dielectric and metal gate processing may be performed and source and drain contacts may be added. In the specific example showing the formation of three gate structures over two silicon-rich nanowires (NMOS) or over two germanium-rich nanowires (PMOS), Figure 5F illustrates the structure following deposition of an NMOS gate stack 530 or a PMOS gate stack 532. The gate stacks may be composed of a high-k gate dielectric layer and an N-type or P-type metal gate electrode layer, respectively. Additionally, Figure 5F depicts the result of the subsequent removal of the interlayer dielectric layer 524 after formation of the permanent gate stack. Contacts may be formed in the place of the interlayer dielectric layer 524 portions remaining in Figure 5E. In an embodiment, at some stage during the process of removing 524 and forming contacts 534, source and drain engineering may also be performed.

In another example, Figure 6 illustrates an angled view of a non-planar semiconductor device having a germanium-based active region with a release etch-passivation surface, useful for understanding the present invention. Referring to Figure 6, a semiconductor device 600 includes a hetero-structure 604 disposed above a substrate 602. The hetero-structure 604 includes a compositional buffer layer 628. A three-dimensional germanium-rich material body 606, such as an essentially pure Ge body, with a channel region 608 is disposed above the compositional buffer layer 628. A gate stack 618 is disposed to surround at least a portion of the channel region 608. The gate stack 618 includes a gate electrode 624 and a gate dielectric layer 620. The gate stack may further include dielectric spacers 640. Source and drain regions 614/616 may be formed in or on portions of the three-dimensional body 606 not surrounded by gate stack 618, or may be formed or adjacent to the channel region 608 (e.g., in the case of embedded regions formed by etching and subsequent epitaxial growth). Also, isolation regions 670 may be included.

In an example, not viewable from the perspective of Figure 6, the gate stack completely surrounds the channel region 608. In that embodiment, a release layer was removed (e.g., a portion of the compositional buffer layer was removed), at least at the channel region 608, e.g., by a selective and passivating wet etch. In one such embodiment, at least the outer surface of the channel region 608 of the body 606 is passivated by sulfur atoms.

Thus, one or more embodiments described herein are targeted at active region arrangements having passivated surfaces. Although described above with respect to benefits for non-planar and gate-all-around devices, benefits may also be achieved for planar devices without gate wrap-around features. Thus, such arrangements may be included to form high mobility material-based transistors such as planar devices, fin or tri-gate based devices, and gate all around devices, including nanowire-based devices. It is to be understood that formation of materials such as the silicon-rich and germanium-rich material layers described herein may be performed by techniques such as, but not limited to, chemical vapor deposition (CVD) or molecular beam epitaxy (MBE), or other like processes.

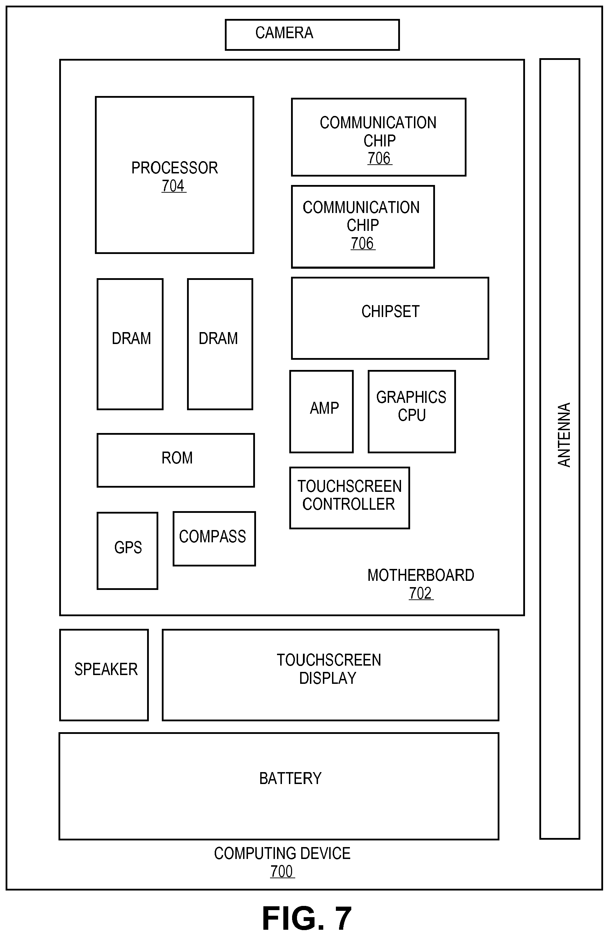

Figure 7 illustrates a computing device 700 comprising a device manufactured using the method of the invention. The computing device 700 houses a board 702. The board 702 may include a number of components, including but not limited to a processor 704 and at least one communication chip 706. The processor 704 is physically and electrically coupled to the board 702. In some implementations the at least one communication chip 706 is also physically and electrically coupled to the board 702. In further implementations, the communication chip 706 is part of the processor 704.

Depending on its applications, computing device 700 may include other components that may or may not be physically and electrically coupled to the board 702. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 706 enables wireless communications for the transfer of data to and from the computing device 700. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some examples they might not. The communication chip 706 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 700 may include a plurality of communication chips 706. For instance, a first communication chip 706 may be dedicated to shorter range wireless communications such as Wi-Fi and Bluetooth and a second communication chip 706 may be dedicated to longer range wireless communications such as GPS, EDGE, GPRS, CDMA, WiMAX, LTE, Ev-DO, and others.

The processor 704 of the computing device 700 includes an integrated circuit die packaged within the processor 704. In some implementations, the integrated circuit die of the processor includes one or more devices, such as MOS-FET transistors built in accordance with implementations of the invention. The term "processor" may refer to any device or portion of a device that processes electronic data from registers and/or memory to transform that electronic data into other electronic data that may be stored in registers and/or memory.

The communication chip 706 also includes an integrated circuit die packaged within the communication chip 706. In accordance with another implementation, the integrated circuit die of the communication chip includes one or more devices, such as MOS-FET transistors built in accordance with implementations of the invention.

In further implementations, another component housed within the computing device 700 may contain an integrated circuit die that includes one or more devices, such as MOS-FET transistors built in accordance with implementations of the invention.

In various implementations, the computing device 700 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 700 may be any other electronic device that processes data.

The present invention is not restricted by the above embodiments, but only by the appended claims. The independent method claim claims the method of the present invention and the dependent claims claim specific embodiments thereof.

## Claims

1. A method of fabricating a nanowire-based semiconductor structure (500), the method comprising:
forming a silicon-rich release layer (504, 508) above a substrate;
forming a germanium-rich active layer (506, 510)) on the silicon-rich release layer;
forming, from the germanium-rich active layer, a germanium-rich nanowire (506, 510);
etching at least a portion of the silicon-rich release layer to form a discrete channel region for the germanium-rich nanowire (506, 510), the etching comprising etching the portion of the silicon-rich release layer while passivating exposed portions of the germanium-rich nanowire (506, 510); and
forming a gate electrode stack completely surrounding the discrete channel region of the germanium-rich nanowire (506, 510), wherein etching the portion of the silicon-rich release layer while passivating exposed portions of the germanium-rich nanowire (506, 510) comprises etching with a wet etchant comprising an aqueous solution of (NH₄)₂S with a % weigh in the range of 1 % - 25 % of (NH₄)₂S.

2. The method of claim 1, wherein the aqueous solution is of approximately 10 % by weight (NH₄)₂S.

3. The method of claim 2, wherein etching with the wet etchant comprises etching at a temperature approximately in the range of 55 - 75 degrees Celsius, and wherein etching with the wet etchant comprises using an etch rate of about 1 nanometer/minute for the silicon-rich material.

4. The method of claim 2, wherein etching with the wet etchant comprises using a pH of approximately 9.

5. The method of claim 1, wherein passivating exposed portions of the germanium-rich nanowire (506, 510) comprises forming terminal sulfur-germanium bonds or bridging sulfur-germanium bonds, or both.

6. The method of claim 1, wherein passivating exposed portions of the germanium-rich nanowire (506, 510) comprises incompletely chemically passivating the exposed portions of the germanium-rich nanowire (506, 510) but sufficiently electrically passivating the exposed portions of the germanium-rich nanowire (506, 510) to inhibit etching of the exposed portions of the germanium-rich nanowire (506, 510) during etching of the silicon-rich release layer.

7. The method of claim 1, wherein etching the portion of the silicon-rich release layer to form the discrete channel region comprises etching a material consisting essentially of silicon or silicon germanium selective to a nanowire (506, 510) consisting essentially of germanium.

8. The method of Claim 1, wherein etching the portion of the silicon-rich release layer to form the discrete channel region comprises etching a material consisting essentially of silicon or silicon germanium with a first germanium concentration selective to a nanowire (506, 510) consisting essentially of silicon germanium with a second, higher, germanium concentration.

## Patentansprüche

1. Verfahren zum Herstellen einer auf Nanodraht beruhenden Halbleiterstruktur (500), wobei das Verfahren Folgendes umfasst:
Bilden einer mit Silizium angereicherten Trennschicht (504, 508) über einem Substrat;
Bilden einer mit Germanium angereicherten, aktiven Schicht (506, 510) auf der mit Silizium angereicherten Trennschicht;
Bilden eines mit Germanium angereicherten Nanodrahtes (506, 510) aus der mit Germanium angereicherten, aktiven Schicht;
Ätzen zumindest eines Abschnitts der mit Silizium angereicherten Trennschicht, um einen einzelnen Kanalbereich für den mit Germanium angereicherten Nanodraht (506, 510) zu bilden, wobei das Ätzen das Ätzen des Abschnitts der mit Silizium angereicherten Trennschicht, während freiliegende Abschnitte des mit Germanium angereicherten Nanodrahtes (506, 510) passiviert werden, umfasst; und
Bilden eines Gate-Elektrodenstapels, der den einzelnen Kanalbereich des mit Germanium angereicherten Nanodrahtes (506, 510) vollständig umgibt, wobei das Ätzen des Abschnitts der mit Silizium angereicherten Trennschicht, während freiliegende Abschnitte des mit Germanium angereicherten Nanodrahtes (506, 510) passiviert werden, das Ätzen mit einem Nassätzmittel, das eine wässrige Lösung von (NH₄)₂S mit einem Gewichtsanteil im Bereich von 1 Gew.-% bis 25 Gew.-% (NH₄)₂S umfasst.

2. Verfahren nach Anspruch 1, wobei die wässrige Lösung näherungsweise 10 Gew.-% (NH₄)₂S aufweist.

3. Verfahren nach Anspruch 2, wobei das Ätzen mit dem Nassätzmittel das Ätzen bei einer Temperatur näherungsweise im Bereich von 55-75 Grad Celsius umfasst und wobei das Ätzen mit dem Nassätzmittel das Verwenden einer Ätzgeschwindigkeit von etwa 1 Nanometer/Minute für das mit Silizium angereicherte Material umfasst.

4. Verfahren nach Anspruch 2, wobei das Ätzen mit dem Nassätzmittel das Verwenden eines pH-Wertes von näherungsweise 9 umfasst.

5. Verfahren nach ■ Anspruch 1, wobei das Passivieren freiliegender Abschnitte des mit Germanium angereicherten Nanodrahtes (506, 510) das Bilden von Abschluss-Schwefel-Germanium-Kontaktierungen und/oder Überbrückungs-Schwefel-Germanium-Kontaktierungen umfasst.

6. Verfahren nach Anspruch 1, wobei das Passivieren freiliegender Abschnitte des mit Germanium angereicherten Nanodrahtes (506, 510) das unvollständige chemische Passivieren der freiliegenden Abschnitte des mit Germanium angereicherten Nanodrahtes (506, 510), jedoch das ausreichende elektrische Passivieren der freiliegenden Abschnitte des mit Germanium angereicherten Nanodrahtes (506, 510), um ein Ätzen der freiliegenden Abschnitte des mit Germanium angereicherten Nanodrahtes (506, 510) während des Ätzens der mit Silizium angereicherten Trennschicht zu unterbinden, umfasst.

7. Verfahren nach Anspruch 1, wobei das Ätzen des Abschnitts der mit Silizium angereicherten Trennschicht, um den einzelnen Kanalbereich zu bilden, das wahlweise Ätzen eines Materials, das im Wesentlichen aus Silizium oder Silizium-Germanium besteht, auf einen Nanodraht (506, 510), der im Wesentlichen aus Germanium besteht, umfasst.

8. Verfahren nach Anspruch 1, wobei das Ätzen des Abschnitts der mit Silizium angereicherten Trennschicht, um den einzelnen Kanalbereich zu bilden, das wahlweise Ätzen eines Materials, das im Wesentlichen aus Silizium oder Silizium-Germanium mit einer ersten Germaniumkonzentration besteht, auf einen Nanodraht (506, 510), der im Wesentlichen aus Silizium-Germanium mit einer zweiten, höheren Germaniumkonzentration besteht, umfasst.

## Revendications

1. Procédé de fabrication d'une structure à semiconducteur à base de nanofil (500), le procédé comprenant :
la formation d'une couche de libération riche en silicium (504, 508) au-dessus d'un substrat ;
la formation d'une couche active riche en germanium (506, 510) sur la couche de libération riche en silicium ;
la formation, à partir de la couche active riche en germanium, d'un nanofil riche en germanium (506, 510) ;
la gravure d'au moins une partie de la couche de libération riche en silicium pour former une région de canal discrète pour le nanofil riche en germanium (506, 510), la gravure comprenant la gravure de la partie de la couche de libération riche en silicium tout en réalisant la passivation de parties apparentes du nanofil riche en germanium (506, 510) ; et
la formation d'une pile d'électrodes de grille entourant complètement la région de canal discrète du nanofil riche en germanium (506, 510), dans lequel la gravure de la partie de la couche de libération riche en silicium tout en réalisant la passivation de parties apparentes du nanofil riche en germanium (506, 510) comprend la gravure avec un agent de gravure humide comprenant une solution aqueuse de (NH₄)₂S avec un % en poids dans la plage de 1 % à 25 % de (NH₄)₂S.

2. Procédé selon la revendication 1, dans lequel la solution aqueuse est d'environ 10 % en poids de (NH₄)₂S.

3. Procédé selon la revendication 2, dans lequel la gravure avec l'agent de gravure humide comprend une gravure à une température approximativement dans la plage de 55 à 75 degrés Celsius, et dans lequel la gravure avec l'agent de gravure humide comprend l'utilisation d'une vitesse de gravure d'environ 1 nanomètre/minute pour le matériau riche en silicium.

4. Procédé selon la revendication 2, dans lequel la gravure avec l'agent de gravure humide comprend l'utilisation d'un pH d'approximativement 9.

5. Procédé selon la revendication 1, dans lequel la passivation de parties apparentes du nanofil riche en germanium (506, 510) comprend la formation de liaisons terminales soufre-germanium ou le pontage de liaisons soufre-germanium, ou les deux.

6. Procédé selon la revendication 1, dans lequel la passivation de parties apparentes du nanofil riche en germanium (506, 510) comprend la passivation chimiquement incomplète des parties apparentes du nanofil riche en germanium (506, 510) mais la passivation suffisamment électrique des parties apparentes du nanofil riche en germanium (506, 510) pour empêcher la gravure des parties apparentes du nanofil riche en germanium (506, 510) pendant la gravure de la couche de libération riche en silicium.

7. Procédé selon la revendication 1, dans lequel la gravure de la partie de la couche de libération riche en silicium pour former la région de canal discrète comprend la gravure d'un matériau consistant sensiblement en silicium ou germanium silicium par rapport à un nanofil (506, 510) consistant sensiblement en germanium.

8. Procédé selon la revendication 1, dans lequel la gravure de la partie de la couche de libération riche en silicium pour former la région de canal discrète comprend la gravure d'un matériau consistant sensiblement en silicium ou silicium-germanium avec une première concentration en germanium par rapport à un nanofil (506, 510) consistant sensiblement en silicium-germanium avec une seconde concentration en germanium, plus grande.
